# EUROPEAN PATENT APPLICATION

(11) **EP 2 690 790 A1**
(43) Date of publication of application: **29.01.2014**
(21) Application number: 12178271.8
(22) Date of filing: 27.07.2012
(51) Int. Cl.: H03M 13/11, H03M 13/27, H03M 13/25

(54) **Bit interleaving for rotated constellations with quasi-cyclic LDPC codes**

(71) Applicant: Panasonic Corporation, Osaka 571-8501 (JP)
(72) Inventor: Petrov, Mihail, 63225 Langen (DE)
(74) Representative: Grünecker, Kinkeldey, Stockmair & Schwanhäusser

(57) **Abstract**

The present invention relates to communication systems that employ rotated multidimensional constellations in conjunction with quasi-cyclic low-density parity-check (LDPC) codes and provides a scheme of mapping the bit interleaver output to the constellation blocks such that each constellation block encodes only two bits of the same quasi-cyclic block. This scheme allows for a particularly efficient hardware implementation of the receiver with a plurality of parallel constellation demapper units. The constellation demapper units are grouped into several demapper banks such that each demapper bank only needs to access two memory banks, i.e., the memory banks holding information on the two bits encoded by the constellation block that is to be decoded by the respective demapper bank. This particular hardware implementation can be used irrespective of the number of dimensions of the constellations employed.

## Description

### TECHNICAL FIELD

The present invention relates to the field of digital communications and more specifically to communication systems that employ rotated constellations in conjunction with quasi-cyclic low-density parity-check (LDPC) codes.

### BACKGROUND OF THE INVENTION

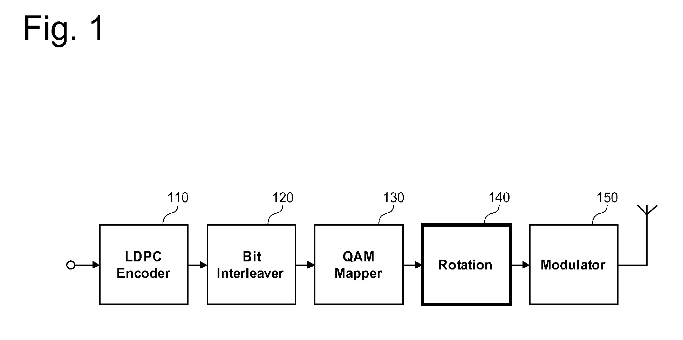

Figure 1 shows the block diagram of a generic transmitter that employs rotated constellations in conjunction with quasi-cyclic LDPC codes. The diagram shows only blocks that are relevant for the present invention.

The transmitter receives at its input binary blocks of a predetermined length, containing the information to be transmitted. Each information block is first encoded by an LDPC (low-density parity-check) encoder 110, the encoding process consisting in computing and adding redundancy bits in order to make the information block more robust against errors.

The bits of the encoded LDPC codeword, thereafter referred to as LDPC block, are interleaved using a bit interleaver 120 and mapped onto complex QAM symbols by means of QAM mapper 130. The real and the imaginary components of the QAM symbols are modulated independently, each component encoding a predefined number of bits, denoted here by B. These two components can be regarded as PAM (pulse amplitude modulation) or ASK (amplitude shift keying) symbols, such a symbol taking a value from a discrete set of 2^{B} values. How the B bits are mapped to PAM symbols is well understood and not directly relevant to the present invention. The relevant aspect is that each FEC block is transformed into a block of real PAM symbols, which are paired into complex QAM symbols.

In order to increase the robustness over fading channels, a dedicated transformation is applied to the symbols generated by the QAM mapper, by multiplying vectors of D real PAM symbols by a DxD square orthogonal matrix. The PAM symbols in each vector can be regarded as identifying unique points in a D-dimensional space, the resulting D^{B} combinations forming a D-dimensional constellation. The matrix multiplication can thus be regarded as a rotation in the D-dimensional space, hence the term rotated constellations. The particular structure of the rotation matrix is not relevant to the present invention.

A good performance with rotated constellations can be achieved my mapping the D components of each constellation to D different complex symbols, which are also referred to as cells. Moreover, the D components are preferably be spread in time and frequency so that the channel fading they experience is as uncorrelated as possible. These aspects are well known in the art.

Finally, the complex symbols are modulated and transmitted over the communication medium. The modulation scheme can be for example OFDM (orthogonal frequency-division multiplexing) and additional interleaving may be performed prior to the modulation in order to increase the diversity of the system.

It is the main goal of the present invention to disclose how the bit interleaver between the LDPC decoder and the QAM mapper can be optimized to allow for an efficient receiver implementation in systems that employ rotated constellations in conjunction with quasi-cyclic LDPC codes.

LDPC codes are linear error-correcting codes that are fully defined by a parity-check matrix (PCM), which is a binary sparse matrix that represents the connection of the codeword bits (also referred to as variable nodes) to the parity checks (also referred to as check nodes). The columns and the rows of the PCM correspond to the variable and the check nodes respectively. Connections of the variable nodes to the check nodes are represented by "1" entries in the PCM.

Quasi-cyclic (QC) LDPC codes have a structure that makes them particularly suitable for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row with one position, and can have one, two, or more cyclically-shifted diagonals. The size of each circulant is QxQ, where Q is referred to as the cyclic factor of the LDPC code. Such a quasi-cyclic structure allows Q check nodes to be processed in parallel, which is clearly advantageous for an efficient hardware implementation.

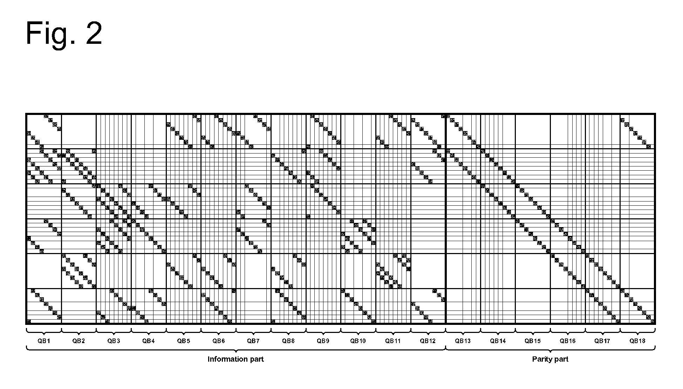

Figure 2 shows the PCM of an example LDPC code with a cyclic factor Q=8, the PCM having circulants with one or two diagonals. This code encodes a block of 8x12=96 bits to a codeword of 8x16=128 bits, having therefore a code rate of 2/3. The codeword bits are subdivided into blocks of Q bits, which will be referred to as cyclic blocks or quasi-cyclic blocks and denoted by QB throughout this document.

The code whose matrix is illustrated in Figure 2 belongs to a special family of QC LDPC codes are the repeat-accumulate (RA) QC LDPC codes. These codes are well known for their ease of encoding and are encountered in a large number of standards, such as the second-generation DVB standards: DVB-S2, DVB-T2, and DVB-C2. For these codes the right-hand side of the PCM, which corresponds to the parity bits, has a staircase structure. These aspects are well understood.

The bit interleaver disclosed in PRDCG 488 is specifically adapted to the structure of a QC LDPC block.

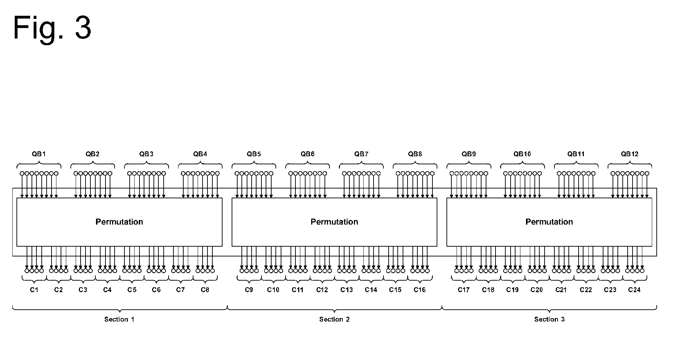

Figure 3 shows the structure of an interleaver that is specifically adapted to the structure of a QC LDPC block. The example LDPC code of Fig. 3 has 12 QBs per codeword and 8 bits per QB (Q=8).

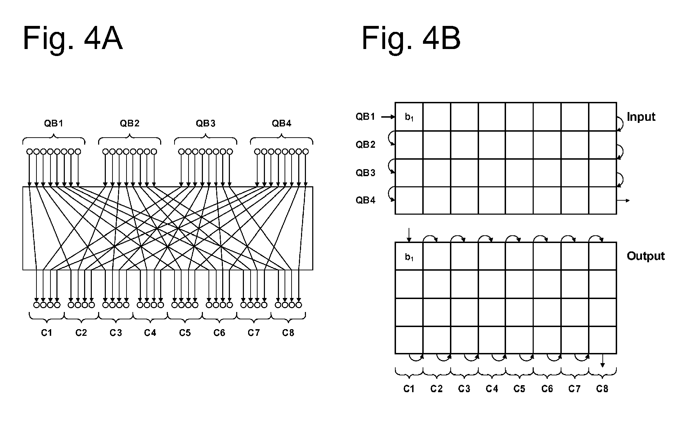

The QBs of an LDPC block are grouped into sections, each section being interleaved separately using a section permutation, as shown in Figure 4A. The number of QBs per interleaving section (four in this example) is a parameter of the interleaver and will be denoted by M throughout this document. The section permutation is performed conceptually by writing the Q*M bits of each section row by row into a matrix with M rows and Q columns and reading them out column by column (cf. Fig. 4B). Thus, the output of the section interleaver consists of groups of M bits, the M bits belonging to M different QBs of the original LDPC block.

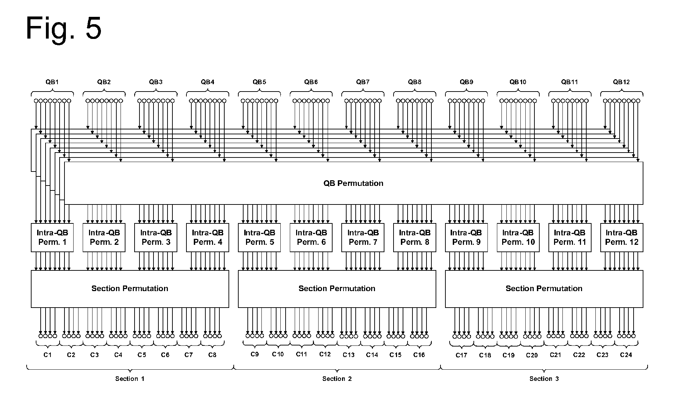

Prior to the grouping of the QBs into sections, the order of the QBs in the LDPC codeword can be changed according to a predefined permutation, referred to as QB permutation. Moreover, additional permutations can be applied to the Q bits of each QBs. These permutations are referred to as intra-QB permutations and are typically cyclic shifts, the shift value being different for each QB. The resulting structure is shown in Figure 5.

While these two kinds of permutations are important for performance optimization, they are not directly relevant to the present invention. In fact, they can be regarded as part of the LDPC code definition. Thus, the QB permutation is equivalent to a permutation of the QB columns in the original PCM, whereas the intra-QB cyclic shifts increment modulo Q the original cyclic shifts of the diagonals in the PCM, the same cyclic shifts being applied to all diagonals in the same QB column.

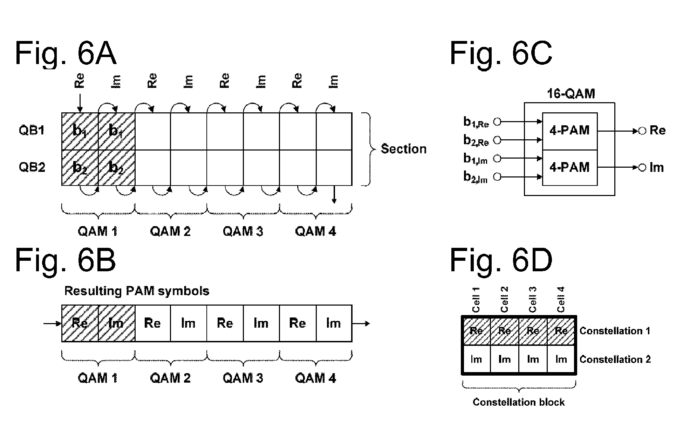

A possible solution for mapping LDPC blocks to QAM constellations consists in mapping each QAM constellation to two adjacent columns of the section permutation matrix. This is equivalent to choosing the parameter M of the bit interleaver (the number of QBs per interleaver section) to be equal to B (the number of bits per PAM symbol). Each PAM symbol will therefore be modulated by the B contiguous bits of one column in the section permutation matrix (Fig. 4B). This is the preferred solution for regular (non-rotated) QAM constellations, and is illustrated in Figs. 6A to 6C for one interleaver section for the case of 16-QAM constellations, with Q=8 for illustration purposes. Typically Q is much larger, e.g. 360 in the DVB-T2 standard.

When rotated constellations are used, a first rotation is applied to D real components of D adjacent complex cells and a second rotation is applied to the remaining D components of the same cells. Preferably, the two rotations are applied to the real and the imaginary components, respectively, as shown in Fig. 6D for D=4. Here the D contiguous complex symbols are also referred to as a constellation block.

A constellation block therefore encodes 2*B*D data bits. When M=B and the above rotation topology is used, each constellation block will have 2*D contiguous bits from each of the M QBs in the respective bit-interleaver section.

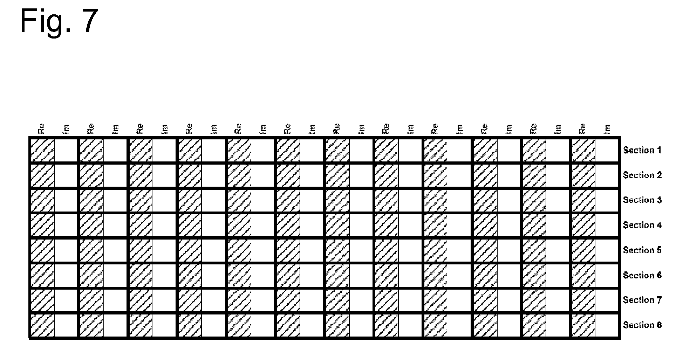

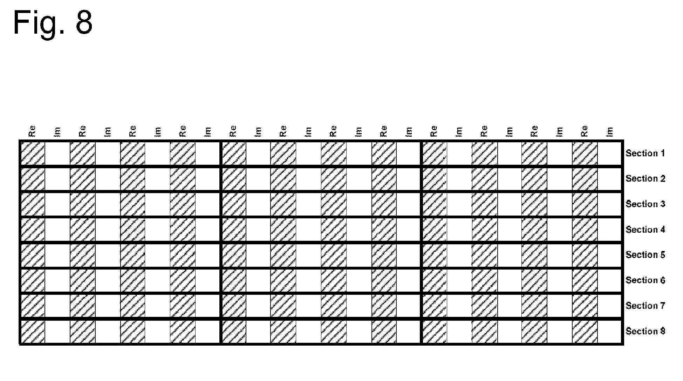

Figs. 7 and 8 show how the output of the bit interleaver is mapped to non-rotated constellations and to 4D rotated-constellation blocks, respectively. The depicted example is for Q=24 and 8 bit-interleaver sections. For the rotated-constellation case the structure of a constellation block is that in Figure 6D.

### SUMMARY OF THE INVENTION

The object of the present invention is to provide a transmitter and a receiver for transmitting and receiving a codeword of a quasi-cyclic low-density parity-check code, as well as corresponding methods, that allow for a particularly efficient hardware implementation, irrespective of the number of dimensions of the employed constellations.

This is achieved by the features as set forth in the independent claims. Preferred embodiments are the subject matter of dependent claims.

It is the particular approach of the present invention to map the bit interleaver output to the constellation blocks such that each constellation block encodes only two bits of the same quasi-cyclic block.

According to a first aspect of the present invention, a method for transmitting a codeword of a quasi-cyclic low-density parity-check code in a digital communication system employing rotated D-dimensional constellations is provided. Each component of the D-dimensional constellations encodes B bits, the codeword consists of N cyclic blocks, and each cyclic block consists of Q bits. The method comprises the steps of dividing the codeword into N/(B*D) sections, each section consisting of M=B*D cyclic blocks; applying a bit permutation to the bits of each section and dividing each of the permuted sections into groups of B bits, wherein the bit permutation is adapted such that the Q bits of each cyclic block are mapped to Q different groups of B bits; mapping each group of B bits to a real-valued symbol, resulting in a sequence of real-valued symbols; dividing the sequence of real-valued symbols into a plurality of D-dimensional vectors and transforming each of the D-dimensional vectors by multiplying the vector with an orthogonal matrix, resulting in a sequence of transformed real-valued symbols; mapping the sequence of transformed real-valued symbols to a sequence of complex symbols such that the D real-valued symbols of each transformed vector are mapped to D different complex symbols; and transmitting (190) the sequence of complex symbols.

According to a further aspect of the present invention, a transmitter for transmitting a codeword of a quasi-cyclic low-density parity-check code in a digital communication system employing rotated D-dimensional constellations is provided. Each component of the D-dimensional constellations encodes B bits, the codeword consists of N cyclic blocks, and each cyclic block consists of Q bits. The transmitter comprises a bit interleaver (110) for dividing the codeword into N/(B*D) sections, each section consisting of M=B*D cyclic blocks, and for applying a bit permutation to the bits of each section and dividing each of the permuted sections into groups of B bits, wherein the bit permutation is adapted such that the Q bits of each cyclic block are mapped to Q different groups of B bits; a constellation mapper (130) for mapping each group of B bits to a real-valued symbol, resulting in a sequence of real-valued symbols; a rotation unit (140) for dividing the sequence of real-valued symbols into a plurality of D-dimensional vectors and for transforming each of the D-dimensional vectors by multiplying the vector with an orthogonal matrix, resulting in a sequence of transformed real-valued symbols; and a modulator (150) for mapping the sequence of transformed real-valued symbols to a sequence of complex symbols such that the D real-valued symbols of each transformed vector are mapped to D different complex symbols, and for transmitting (190) the sequence of complex symbols.

In a preferred embodiment, the step of applying the bit permutation is performed by applying a column-row permutation on the M.Q bits of the section, the column-row permutation being equivalent to writing the M.Q bits column-wise into a matrix with Q columns and M rows and reading out the permuted bits row-wise. Such a column-row permutation allows for a particular efficient hardware implementation.

Preferably, the mapping of the sequence of transformed real-valued symbols to the sequence of complex symbols is performed such that the D real-valued symbols of each transformed vector are mapped to either D real components of D consecutive complex symbols or to D imaginary components of D consecutive complex symbols.

Preferably, the mapping of the sequence of transformed real-valued symbols to the sequence of complex symbols is performed such that the 2*D real-valued symbols of two consecutive transformed vectors are mapped to D consecutive complex symbols.

According to a further aspect of the present invention, a method for receiving a codeword of a quasi-cyclic low-density parity-check code in a digital communication system employing rotated D-dimensional constellations is provided. Each component of the D-dimensional constellations encodes B bits, the codeword consists of N cyclic blocks, and each cyclic block consists of Q bits. The method comprises the steps of receiving a sequence of complex symbols; de-mapping the sequence of complex symbols to a sequence of transformed vectors, each transformed vector consisting of D real-valued symbols; de-mapping each transformed vector to B*D bits, resulting in a permuted codeword; dividing the permuted codeword into N/(B*D) sections, each section consisting of M=B*D cyclic blocks; recovering the codeword by applying an inverse of a bit permutation to the bits of each section, the bit permutation being adapted such that the Q bits of each cyclic block are mapped to Q different groups of B bits.

According to a further aspect of the present invention, a receiver for receiving a codeword of a quasi-cyclic low-density parity-check code in a digital communication system employing rotated D-dimensional constellations is provided. Each component of the D-dimensional constellations encodes B bits, the codeword consists of N cyclic blocks, and each cyclic block consists of Q bits. The receiver comprises a demodulator (250) for receiving a sequence of complex symbols; a constellation demapper (230) for de-mapping the sequence of complex symbols to a sequence of transformed vectors, each transformed vector consisting of D real-valued symbols, and for de-mapping each transformed vector to B*D bits, resulting in a permuted codeword; and a bit deinterleaver (220) for dividing the permuted codeword into N/(B*D) sections, each section consisting of M=B*D cyclic blocks, and for recovering the codeword by applying an inverse of a bit permutation to the bits of each section, the bit permutation being adapted such that the Q bits of each cyclic block are mapped to Q different groups of B bits.

In a preferred embodiment, the inverse of the bit permutation is a column-row permutation, which is equivalent to writing the M.Q bits of the section row-wise into a matrix with Q columns and M rows and reading out the permuted bits column-wise. Such a column-row permutation allows for a particular efficient hardware implementation.

Moreover, the receiver may further comprise an LDPC decoder for decoding a block of data bits from the recovered codeword. In this case, the receiver according to a particularly preferred embodiment may further comprise a first memory for storing soft bits of the codeword, each soft bit indicating an a-posteriori probability of the respective codeword bit, the first memory being divided into P parallel memory banks, P being a divisor of Q. Further, the constellation demapper preferably comprises a plurality of constellation demapper units, the plurality of constellation demapper units being divided into P/2 demapper banks, each demapper bank being configured to access two adjacent memory banks of the first memory, each demapper unit being adapted for extracting soft bits of the codeword from a complex symbol of the sequence of complex symbols and for storing the extracted soft bits in the first memory. Moreover, the LDPC decoder is preferably adapted for decoding the codeword on the basis of the soft bits stored in the first memory. This results in a particularly efficient hardware implementation, irrespective of the number of dimensions of the constellations employed.

In case that an iterative form of decoding is employed, the receiver may further comprise a second memory for storing the sequence of complex symbols, the second memory being divided into P parallel memory banks, wherein each demapper bank is further configured to access two adjacent memory banks of the second memory.

Preferably, the constellation demapper is adapted for storing Q/P soft bits of each cyclic block in each memory bank.

In preferred embodiments, each component of the D-dimensional constellations encodes B=1, B=2, B=3, or B=4 bits. The number of dimensions may be D=2, D=4 or D=8. However, the present invention is not restricted to these examples and may also be employed for more bits per component or for higher dimensional constellations.

The above and other objects and features of the present invention will become more apparent from the following description and preferred embodiments given in conjunction with the accompanying drawings, in which:
- Fig. 1: is a block diagram of a generic transmitter for rotated constellations and LDPC codes;
- Fig. 2: illustrates a parity-check matrix of an example quasi-cyclic LDPC code;
- Fig. 3: illustrates an example bit interleaver for quasi-cyclic LDPC codes;
- Fig. 4A: illustrates the row-column interleaving of each bit-interleaver section of the bit interleaver of Fig. 3;
- Fig. 4B: is another illustration of the row-column interleaving of Fig. 4A;
- Fig. 5: shows the structure of an example bit interleaver with additional QB and intra-QB permutations;
- Figs. 6A-C: illustrates the conventional mapping of the output of the bit interleaver to 16-QAM constellations;
- Fig. 6D: illustrates the mapping of a pair of 4D rotated constellations to four adjacent cells;
- Fig. 7: illustrates the conventional mapping of the output of the bit interleaver to non-rotated constellations;
- Fig.8: illustrates the conventional mapping of the output of the bit interleaver to 4D rotated-constellation blocks;
- Fig. 9A: is a block diagram of a receiver with non-iterative decoding;
- Fig. 9B: is a block diagram of a receiver with iterative decoding;
- Fig. 10: is a more detailed block diagram of an iterative decoder;
- Fig. 11: illustrates the structure of a parallel iterative decoder for quasi-cyclic LDPC codes;
- Fig. 12: illustrates the structure of a parallel non-iterative decoder for quasi-cyclic LDPC codes;
- Fig. 13: illustrates the storing of LDPC bits in memory banks;
- Fig. 14: illustrates the storing of received complex cells in memory banks;
- Fig. 15: illustrates a compact and regular structure of a hardware iterative decoder;
- Fig. 16A: illustrates the mapping of an LDPC block to constellation blocks according to an embodiment of the present invention;
- Figs. 16B-D: illustrate different options for constructing rotated-constellation blocks from PAM symbols; and
- Fig. 17: illustrates the mapping of interleaved bits to constellation blocks.

### DETAILED DESCRIPTION

The conventional approach for implementing rotated constellations results in increased receiver complexity. This is due to the fact that the number of bits that a constellation block has from each QB of the corresponding bit-interleaver section depends on the number of rotated-constellation dimensions D. More specifically, this number is 2*D, as explained above. This fact alone is not necessarily a problem. However, if the same receiver needs to support a variable number of dimensions, e.g. 1, 2, 4, and 8, the implementation efficiency would suffer. This is especially true for receivers that use iterative decoding.

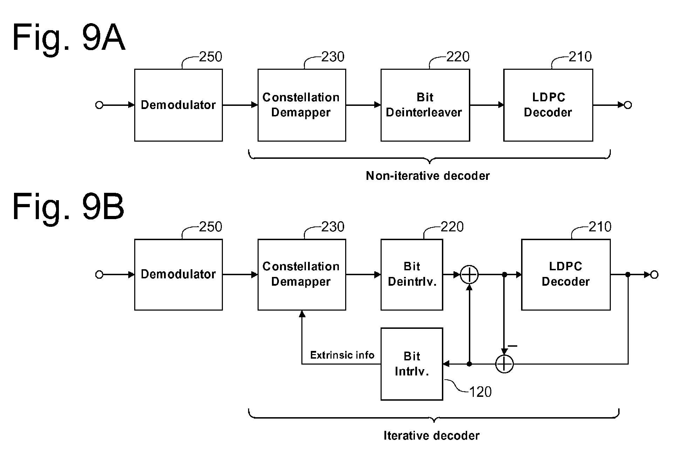

In order to better understand why this is so, it is necessary to take a closer look at the structure of the decoder. The generic block diagrams of a receiver with non-iterative and iterative decoding are illustrated in Figs 9A and 9B, respectively. It can be easily seen that the structure of the non-iterative receiver corresponds to the transmitter in Fig. 1, the only difference being that the de-rotation and the QAM demapping are performed by a single block, i.e., by the constellation demapper 230. Performing the two operations jointly is a prerequisite for optimal decoding performance.

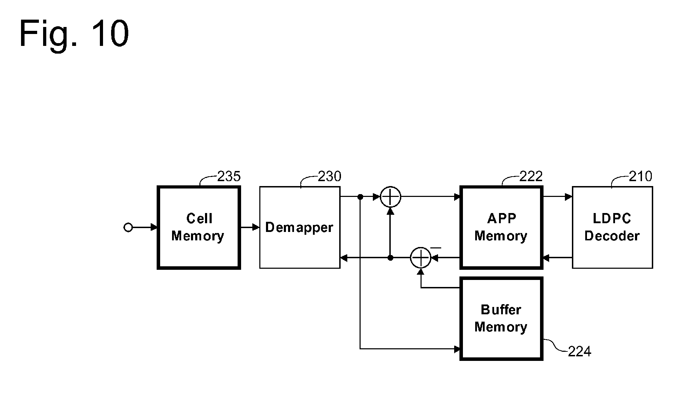

Iterative decoding is a technique which consists in performing the constellation demapping and the LDPC decoding iteratively, the two processes helping each other by exchanging extrinsic information. The decoding performance can thereby be improved significantly. A more detailed block diagram of an iterative decoder is illustrated in Figure 10, in which the bit interleaver 120 and deinterleaver 220 are omitted for the sake of clarity. Particularly important in this structure are the three memory blocks, namely the cell memory 235, the APP memory 222, and the buffer memory 224. The cell memory 235 stores the complex cells produced by the demodulator 250, so that they are available to the demapper 230 throughout the iterative decoding process. The APP memory 222 stores the a-posteriori probabilities of the bits, which are updated constantly during the decoding process. The buffer memory 224 stores the initial APPs, as produced by the demapper 230, which are needed for computing the extrinsic APP information.

Refering to the block diagram of Figure 10, the operation of an iterative decoder is briefly explained. In the first iteration, the demapper 230 has no a-priori information from the LDPC decoder 210 and performs a blind (not aided by a-priori information) demapping of the received complex symbols, the demapping consisting in extracting soft bits from the received complex cells stored in the cell memory 235. The demaped soft bits (which are measures of the a-posteriori bit probabilities, typically expressed as log-likelihood ratios) are directly written to the APP memory 222 and also to the buffer memory 224. Once the bits of the LDPC codeword have been written to the APP memory 222, one or more LDPC decoding iterations are performed. In the process, the APP memory 222 is updated in place. How this can be done is well understood in the art. After one or more LDPC iterations, an outer iteration over the demapper 230 is performed, the outer iteration consisting of the following steps: computing the extrinsic APP information by subtracting the buffered initial APPs from the updated APPs, feeding the extrinsic information as a-priori information to the demapper 230, computing updated soft bits using the a-priori information, adding the extrinsic information to the updated soft bits, and writing the result back to the APP memory 222. These basic principles of iterative decoding are well understood in the art and do not require further explanations.

What is important for the understanding of the invention, however, is the more detailed structure of a parallel iterative decoder for quasi-cyclic LDPC codes.

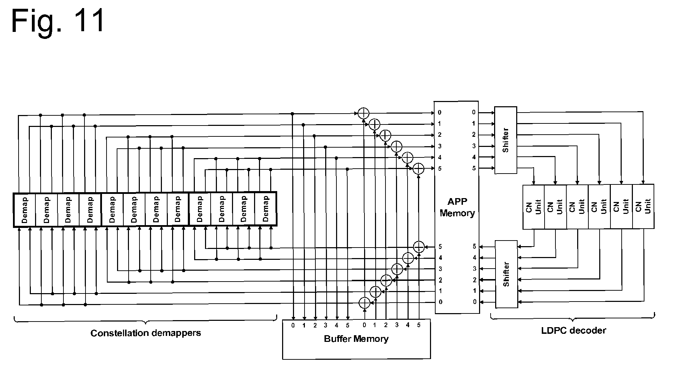

An example of such a structure is illustrated in Fig. 11 for non-rotated constellations (see Fig. 7). It can be seen that this structure matches exactly the structure in Figure 10, apart from the cell memory, which was left out for the sake of clarity. The structure is highly parallel, having several identical demapper instances, which enables very high throughputs. Such a highly parallel structure is made possible by the inherently parallel structure of the quasi-cyclic LDPC codes and of the bit interleaver described above. The structure of the LDPC decoder, consisting of cyclic shifters and check-node units, is well understood in the art and requires no further explanations.

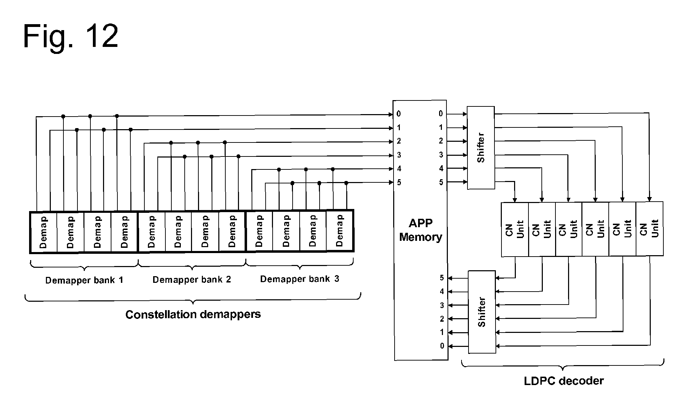

For the sake of completeness, Figure 12 shows the structure of an equivalent non-iterative decoder. Unlike an iterative decoder, there is no buffer memory, no adders or subtractors, and the demappers have no a-priori inputs. Typically, there is no cell memory either.

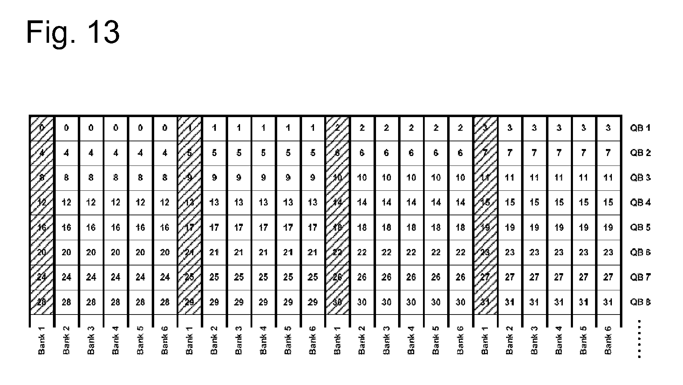

In order to achieve the throughput required by the demappers, the APP memory is typically implemented using several banks in parallel. The designer is free to choose any number of memory banks that is a divisor of Q. In the following, this number is denoted by P and is a measure of the degree of parallelism, and thus the single most important design parameter. Fig. 13 shows an example of how the LDPC bits can be stored in the memory banks, for Q=24 and P=6. The squares represent (soft) bits of the LDPC block and the numbers in the squares indicate the address of each bit in its corresponding memory bank. For clarity, the hatched squares identify the bits in the first memory bank.

It can be easily seen that each QB (quasi-cyclic block) has Q/P=4 bits in each memory bank. It is also worth noting that the number of QBs per LDPC block determines the size of the memory banks but not the number of banks, so exactly the same physical structure can be reused for multiple LDPC block sizes if their Q is the same.

A novel aspect of this implementation is that a similar banked memory structure is also used for the cell memory in Figure 10. Although this memory is not explicitly shown in Fig. 11, it is nevertheless an essential part of the iterative decoder.

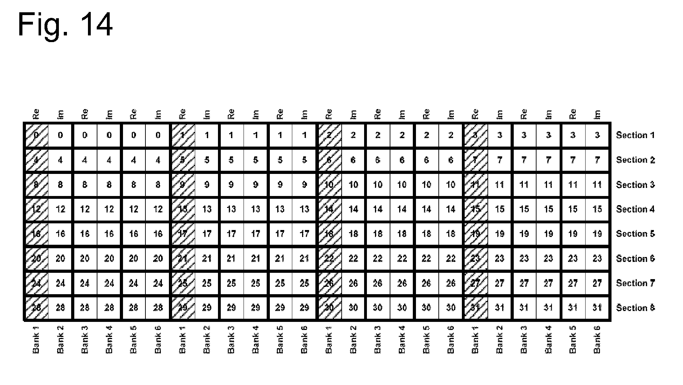

When the mapping in Fig. 7 is used, the resulting memory layout is illustrated in Fig. 14. Thus, the real and the imaginary components of the complex cells are stored in odd and even banks, respectively. In the figure the thick borders group the two components of the same complex cell.

The demappers are arranged between the cell memory banks and the APP memory banks. According to an aspect of the invention, the demappers are also grouped into banks, the number of banks being equal to half the number of memory banks. The reason is that each demapper needs to access both the real and the imaginary components of a complex cell, which are stored in different memory banks. A demapper bank can in turn contain one or more demappers. Preferably, the number of demappers in a demapper bank is chosen so that the total number of demappers is a divisor or a multiple of Q. Thus, for the scenario illustrated in Fig. 14 the number of demappers per bank can be 1, 2, 4, or any multiple of 4. This number is a design parameter and directly determines the maximum throughput that can be achieved by the iterative decoder.

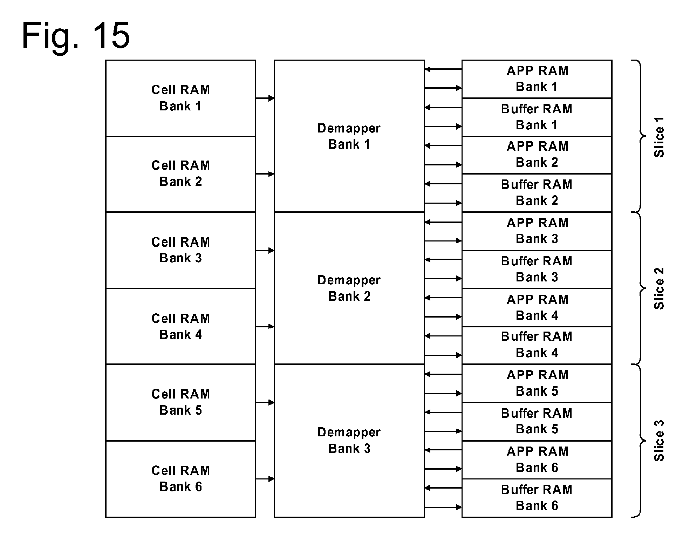

It is important to understand how efficiently the schematic in Fig. 11 can implemented in a real hardware structure. Thanks to the high parallelism and the local data transfers, the resulting hardware structure (shown in Fig. 15) is very compact and regular, which dramatically reduces the amount of wire routing and thus the signal propagation delay and the hardware area, leading to a cheaper and faster implementation. Note that the adders in Figure 11 have been included in the demapper banks to improve clarity.

The primary reason why the wire routing is so compact is that the each demapper bank is connected to two adjacent banks of each of the three memories. These memory banks can easily be placed in the immediate vicinity of their associated demapper bank. The block layout of the decoder is thus naturally divided into P/2 identical slices, which also contributes to an efficient hardware implementation.

Since the above implementation is so efficient, it is highly desirable to be able to also decode rotated constellations using exactly the same structure. The inventor realized that this is not possible when the prior-art solution (see Figure 8) is used. Since each constellation block encodes 2*D adjacent bits from a QB, each demapper would have to be connected to 2*D memory banks. This would significantly complicate the wire routing since a different wiring configuration would be needed for each value of D.

Moreover, the freedom of the designer in choosing the number of memory banks (and thus the parallelism of the decoder) would be constrained by the fact that the number of banks would have to be a multiple of 2*D.

It is therefore highly desirable to have each demapper bank connected to only two memory banks regardless of the value of D. This can be achieved by the present invention.

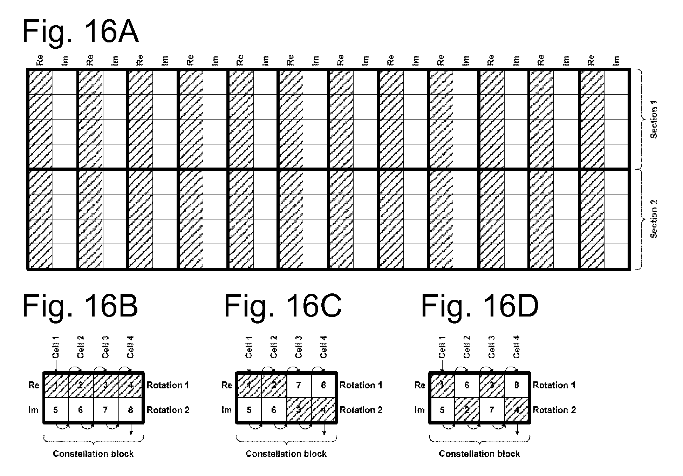

According to the main aspect of the invention, the mapping of the bit interleaver output to the constellation blocks must be performed so that each constellation block encodes only two bits from the same QB. This is illustrated in Figure 16A for D=4. The difference to the prior-art solution in Fig. 8 is readily apparent. Concretely, this mapping configuration can be achieved if the M parameter (the number of QBs per bit-interleaver section) is chosen to be equal to B*D instead of B like in the prior art. The number of bit-interleaver sections will therefore decrease by D, as apparent from Fig. 16A.

More exactly, the desired mapping is achieved by performing the steps of:
1. Applying a parallel bit interleaver with M=B*D to the LDPC block
2. Mapping each contiguous group of B bits to a real PAM symbol
3. Applying a first and second rotation to the first and second group of D contiguous PAM symbols in the group of 2*D contiguous PAM symbols
4. Mapping the resulting D real symbols of the first group to D real or imaginary components of D adjacent complex cells, and mapping the resulting D real symbols to the remaining D components of said complex cells.

Preferably, the D real symbols of the first and second group are mapped to the real and the imaginary components of said complex cells, respectively. This solution is illustrated in Figure 16B a for D=4. The numbers in the squares denote the indices of the real symbols. Two alternative possibilities are shown in Figs. 16C and 16D, respectively.

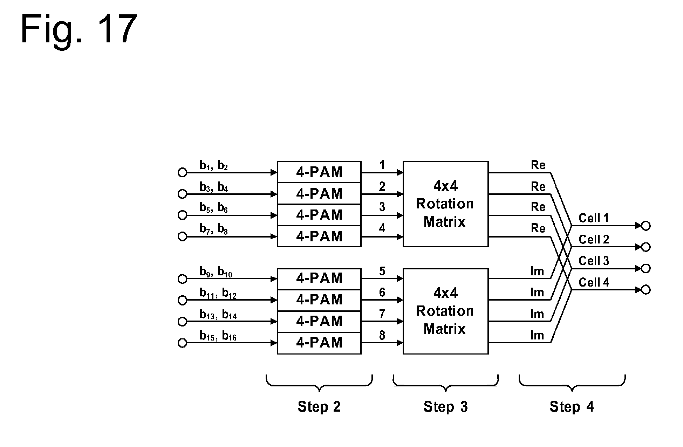

Steps 2 through 4 are further illustrated in Fig. 17 (for B=2 and D=4), where the mapping of the 2*D real symbols to the D adjacent complex cells is performed according to the preferred option of Fig. 16B.

Summarizing, the present invention relates to communication systems that employ rotated multi-dimensional constellations in conjunction with quasi-cyclic low-density parity-check (LDPC) codes and provides a scheme of mapping the bit interleaver output to the constellation blocks such that each constellation block encodes only two bits of the same quasi-cyclic block. This scheme allows for a particularly efficient hardware implementation of the receiver with a plurality of parallel constellation demapper units. The constellation demapper units are grouped into several demapper banks such that each demapper bank only needs to access two memory banks, i.e., the memory banks holding information on the two bits encoded by the constellation block that is to be decoded by the respective demapper bank. This particular hardware implementation can be used irrespective of the number of dimensions of the constellations employed.

## Claims

1. A method for transmitting a codeword of a quasi-cyclic low-density parity-check code in a digital communication system employing rotated D-dimensional constellations, each component of the D-dimensional constellations encoding B bits, the codeword consisting of N cyclic blocks, each cyclic block consisting of Q bits, the method comprising the steps of:
dividing the codeword into N/(B*D) sections, each section consisting of M=B*D cyclic blocks;
applying a bit permutation to the bits of each section and dividing each of the permuted sections into groups of B bits, wherein the bit permutation is adapted such that the Q bits of each cyclic block are mapped to Q different groups of B bits;
mapping each group of B bits to a real-valued symbol, resulting in a sequence of real-valued symbols;
dividing the sequence of real-valued symbols into a plurality of D-dimensional vectors and transforming each of the D-dimensional vectors by multiplying the vector with an orthogonal matrix, resulting in a sequence of transformed real-valued symbols;
mapping the sequence of transformed real-valued symbols to a sequence of complex symbols such that the D real-valued symbols of each transformed vector are mapped to D different complex symbols; and
transmitting (190) the sequence of complex symbols.

2. The method according to claim 1, wherein the step of applying the bit permutation is performed by applying a column-row permutation on the M•Q bits of the section, the column-row permutation being equivalent to writing the M.Q bits row-wise into a matrix with Q columns and M rows and reading out the permuted bits column-wise.

3. The method according to claim 1 or 2, wherein the step of mapping the sequence of transformed real-valued symbols to the sequence of complex symbols is performed such that the D real-valued symbols of each transformed vector are mapped to either D real components of D consecutive complex symbols or to D imaginary components of D consecutive complex symbols.

4. The method according to any of claims 1 to 3, wherein the step of mapping the sequence of transformed real-valued symbols to the sequence of complex symbols is performed such that the 2*D real-valued symbols of two consecutive transformed vectors are mapped to D consecutive complex symbols.

5. A method for receiving a codeword of a quasi-cyclic low-density parity-check code in a digital communication system employing rotated D-dimensional constellations, each component of the D-dimensional constellations encoding B bits, the codeword consisting of N cyclic blocks, each cyclic block consisting of Q bits, the method comprising the steps of:
receiving a sequence of complex symbols;
de-mapping the sequence of complex symbols to a sequence of transformed vectors, each transformed vector consisting of D real-valued symbols;
de-mapping each transformed vector to B*D bits, resulting in a permuted codeword;
dividing the permuted codeword into N/(B*D) sections, each section consisting of M=B*D cyclic blocks;
recovering the codeword by applying an inverse of a bit permutation to the bits of each section, the bit permutation being adapted such that the Q bits of each cyclic block are mapped to Q different groups of B bits.

6. The method according to claim 5, wherein the step of applying the inverse of the bit permutation is performed by applying a column-row permutation on the M•Q bits of the section, the column-row permutation being equivalent to writing the M•Q bits column-wise into a matrix with Q columns and M rows and reading out the permuted bits row-wise.

7. The method of any of claims 1 to 6, wherein B=1 or B=2 or B=3 or B=4 or D=2 or D=4 or D=8.

8. A transmitter for transmitting a codeword of a quasi-cyclic low-density parity-check code in a digital communication system employing rotated D-dimensional constellations, each component of the D-dimensional constellations encoding B bits, the codeword consisting of N cyclic blocks, each cyclic block consisting of Q bits, the transmitter comprising:
a bit interleaver (110) for dividing the codeword into N/(B*D) sections, each section consisting of M=B*D cyclic blocks, and for applying a bit permutation to the bits of each section and dividing each of the permuted sections into groups of B bits, wherein the bit permutation is adapted such that the Q bits of each cyclic block are mapped to Q different groups of B bits;
a constellation mapper (130) for mapping each group of B bits to a real-valued symbol, resulting in a sequence of real-valued symbols;
a rotation unit (140) for dividing the sequence of real-valued symbols into a plurality of D-dimensional vectors and for transforming each of the D-dimensional vectors by multiplying the vector with an orthogonal matrix, resulting in a sequence of transformed real-valued symbols;
a modulator (150) for mapping the sequence of transformed real-valued symbols to a sequence of complex symbols such that the D real-valued symbols of each transformed vector are mapped to D different complex symbols, and for transmitting (190) the sequence of complex symbols.

9. A receiver for receiving a codeword of a quasi-cyclic low-density parity-check code in a digital communication system employing rotated D-dimensional constellations, each component of the D-dimensional constellations encoding B bits, the codeword consisting of N cyclic blocks, each cyclic block consisting of Q bits, the receiver comprising:
a demodulator (250) for receiving a sequence of complex symbols;
a constellation demapper (230) for de-mapping the sequence of complex symbols to a sequence of transformed vectors, each transformed vector consisting of D real-valued symbols, and for de-mapping each transformed vector to B*D bits, resulting in a permuted codeword;
a bit deinterleaver (220) for dividing the permuted codeword into N/(B*D) sections, each section consisting of M=B*D cyclic blocks, and for recovering the codeword by applying an inverse of a bit permutation to the bits of each section, the bit permutation being adapted such that the Q bits of each cyclic block are mapped to Q different groups of B bits.

10. The receiver according to claim 9, wherein the bit deinterleaver (220) is adapted for performing the inverse of the bit permutation by applying a column-row permutation on the M•Q bits of the section, the column-row permutation being equivalent to writing the M•Q bits row-wise into a matrix with Q columns and M rows and reading out the permuted bits column-wise.

11. The receiver according to claim 9 or 10, further comprising an LDPC decoder (210) for decoding a block of data bits from the recovered codeword.

12. The receiver according to claim 11, further comprising:
a first memory (222) for storing soft bits of the codeword, each soft bit indicating an a-posteriori probability of the respective codeword bit, the first memory (222) being divided into P parallel memory banks, P being a divisor of Q,
wherein the constellation demapper (230) comprises a plurality of constellation demapper units (Demap), the plurality of constellation demapper units (Demap) being divided into P/2 demapper banks, each demapper bank being configured to access two adjacent memory banks of the first memory, each demapper unit (Demap) being adapted for extracting soft bits of the codeword from a complex symbol of the sequence of complex symbols and for storing the extracted soft bits in the first memory, and
wherein the LDPC decoder (210) is adapted for decoding the codeword on the basis of the soft bits stored in the first memory.

13. The receiver of claim 12, further comprising
a second memory (235) for storing the sequence of complex symbols, the second memory (235) being divided into P parallel memory banks;
wherein each demapper bank is further configured to access two adjacent memory banks of the second memory (235).

14. The receiver of claim 12 or 13, wherein the constellation demapper (230) is adapted for storing Q/P soft bits of each cyclic block in each memory bank.
